(19) **Europäisches Patentamt**
**European Patent Office**
**Office européen des brevets**

(11) **EP 0 649 589 B1**

(12) **EUROPEAN PATENT SPECIFICATION**

(45) Date of publication and mention
of the grant of the patent:
**19.05.1999 Bulletin 1999/20**

(51) Int Cl.⁶: **H04S 7/00**, H04S 1/00,
H03H 21/00

(21) Application number: **93914879.7**

(86) International application number:
**PCT/GB93/01402**

(22) Date of filing: **05.07.1993**

(87) International publication number:
**WO 94/01981 (20.01.1994 Gazette 1994/03)**

(54) **ADAPTIVE AUDIO SYSTEMS AND SOUND REPRODUCTION SYSTEMS**

ADAPTIVE AUDIOSYSTEME UND TONWIEDERGABESYSTEME

SYSTEMES AUDIO-ADAPTATIFS ET SYSTEMES DE REPRODUCTION SONORE

(84) Designated Contracting States:
**AT BE CH DE DK ES FR GR IE IT LI LU MC NL PT SE**

(30) Priority: **06.07.1992 GB 9214340**
**26.04.1993 GB 9308570**

(43) Date of publication of application:
**26.04.1995 Bulletin 1995/17**

(73) Proprietor: **ADAPTIVE AUDIO LIMITED**
**Southampton, Hampshire SO2 3HY (GB)**

(72) Inventors:
• **NELSON, Philip Arthur**
**Southampton, Hampshire SO2 3HY (GB)**

• **ORDUNA-BUSTAMANTE, Felipe**
**Southampton, Hampshire SO1 7GG (GB)**
• **HAMADA, Hareo**
**Musashino-city, Tokyo 180 (JP)**

(74) Representative: **Lomas, Geoffrey Michael et al**
**Barker Brettell**
**Medina Chambers,**
**Town Quay**
**Southampton SO14 7AQ (GB)**

(56) References cited:
EP-A- 0 357 402        WO-A-90/00851
DE-A- 4 027 338        US-A- 3 236 949
US-A- 3 956 709        US-A- 4 219 696

**Description**

This invention relates to sound reproduction systems and more particularly to sound reproduction systems incorporating multi-channel signal processing techniques.

The invention is concerned with sound reproduction systems arranged to generate 'virtual source locations' of sound at positions other than those of actual loudspeakers employed to reproduce a sound field.

WO-A-9 000 851 and EP-A-0 450 819 each relates to sound reproduction systems comprising loudspeaker drive means for a plurality of loudspeakers, wherein the loudspeaker drive means comprise digital filter means.

The relevant teaching of these references are acknowledged in the precharacterising portion of the following paragraph.

According to the present invention, a sound reproduction system comprises a plurality of loudspeakers for positioning at positions spaced from a listener location, loudspeaker drive means for driving the loudspeakers in response to a plurality of channels of a sound recording, the loudspeaker drive means comprising a filter means, the sound recording being suitable for playing normally through a plurality of speakers normally positioned generally symmetrically with respect to a listener location, characterised in that the filter means comprise digital filter means and the characteristics of the digital filter means are so chosen as to create, in use of the reproduction system, at the listener location a local sound field which is substantially equivalent to the local field that would result from playing the sound recording through a plurality of loudspeakers driven without said digital filter means and positioned at virtual source locations, at least one of the virtual source locations being displaced substantially from the actual location of the corresponding loudspeaker, the digital filter means being designed in order to approximately reproduce in the sound field the desired signals which are specified by the use of a filter matrix used to relate the desired signals to the recorded signals.

Thus, the digital filter means is arranged to compensate for the asymmetric positioning of the loudspeakers with respect to the listener location.

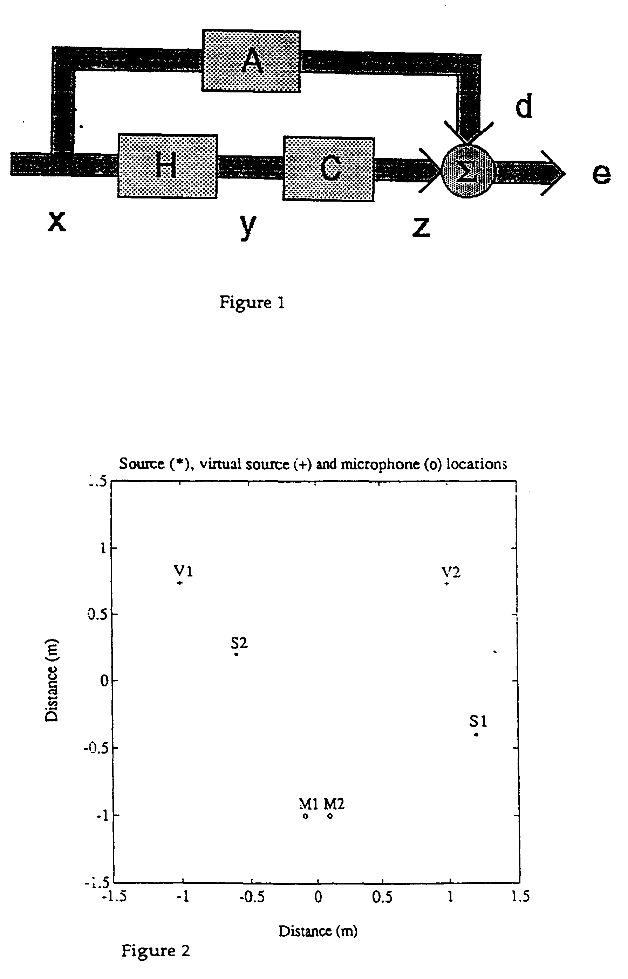

For example, with reference to Figure 1, a transfer function matrix $C(z)$ of electro-acoustic transfer functions relates loudspeaker inputs to the outputs of microphones placed at the location of the listener ears in the sound field. A matrix $H(z)$ of inverse digital filters can be used to process conventional two-channel stereophonic recorded signals prior to transmission by the loudspeakers in order to produce the desired effect, as specified by a matrix $A(z)$ at microphones placed in a sound field. Matrix $A(z)$ is the transfer function matrix relating the recorded signals to the signals that are desired to be reproduced at the microphones, and the matrix $A(z)$ in accordance with the invention is selected by assuming that we have the said specified virtual source locations.

Each of the virtual source locations is preferably displaced from the actual location of the corresponding loudspeakers.

Thus the digital filter means is arranged to create an impression at the listener location that the loudspeakers are more widely spaced than is actually the case.

The sound reproduction system may employ four loudspeakers which are arranged in use at spaced-apart positions to create a sound field, with first and second predetermined listener locations within the sound field, the loudspeakers being driven through digital filter means by two channels through a pair of loudspeakers positioned symmetrically with respect to the respective location.

Such a sound reproduction system may be characterised in that said digital filter means comprise adaptive filter means having a plurality of alterable filter coefficients, a processor implementing an algorithm which cyclically performs in turn a filtering operation utilising the filter, and a filter updating operation to update the filter coefficients, the algorithm being arranged in a cycle thereof to adjust (if necessary) only a limited number of the filter coefficients before performing a filtering operation.

Preferably only one coefficient of the adaptive filter means is adjusted in each cycle.

The algorithm is preferably the LMS algorithm (2) of the filtered-x LMS algorithm (3). In the latter case, the filtered reference signal employed can be calculated on a single-tap basis.

It is shown hereafter that adjustment of the adaptive filter means reduces the operation count by a factor of 2 in the case of the LMS algorithm and by a factor of 3 in the case of the filtered-x LMS algorithm. More importantly, the bulk of the computational work that remains to be done is mainly related to the actual filtering operation. These calculations can be performed by a dedicated filtering unit external to the main processor and then most of the processing time can be dedicated to update the filter. This technique can be easily extended to complex systems based on a number of adaptive filters having arbitrary lengths. This is an ability which is highly desirable in multi-channel applications.

INTRODUCTION

Digital filters can be used to operate on recorded signals prior to their transmission via loudspeakers in order to enhance the reproduction of those signals. In the simplest case, an inverse filter can be designed in order to compensate for deficiencies in a loudspeaker/room frequency response. Such a filter can be designed to produce a transfer function between the filter input and the sound pressure at a point in the sound field which has a "flat" magnitude response and a linear phase response; in time domain terms, an impulse applied to the input can be "almost perfectly" reproduced (at a little time later) at the output. The purpose of the work presented here however, is to demonstrate that this principle can be extended to the multi-channel case and to illustrate the considerable potential for the use of multi-channel inverse filters in the reproduction of sound. In Section 1, the background to the filter design problem is reviewed briefly before the solution to the multi-channel problem is presented. The filter design problem falls naturally into a least squares framework, even though filters designed with a least squares objective may not ultimately provide the best psychoacoustical benefits. The basis of the iiiter design technique assumes that measurements can be made in the reproduced sound field in order to compare the reproduced signals with the signals that are desired to be reproduced. The fact that the filters can therefore be designed adaptively opens up the possibility of tailoring the individual filters to the requirements of a particular listening space. However, the filters do not necessarily have to be adaptive and modified to accommodate changes in listening room acoustics; the design process can equally well be used in order to establish fixed filters used, for example to modify the position of stereophonic images in an in-car entertainment system. It is the latter topic that we address in Section 2, where computer simulations are presented which demonstrate some interesting possibilities. In particular, it is shown that a matrix of inverse filters can be used to provide "virtual source" locations at positions other than those of the actual loudspeakers. Furthermore, the possibility is examined of providing multiple "ideal listening positions"; it is demonstrated that an appropriately designed filter matrix can be used to operate on the two channels of a stereophonic recording in order to closely reproduce these signals at two pairs of points in the reproduced field. The ultimate test of these possibilities will of course be psychoacoustical. In the meantime however, attention will be concentrated on the physical aspects of the problem.

## 1. MULTI-CHANNEL INVERSE FILTERING USING A LEAST SQUARES FORMULATION

### 1.1 Background to least squares filter design

The design of digital filters for single channel equalisation is most readily approached using traditional "least squares" methods. This technique has its roots in the dassical approach of Wiener [1] in which the impulse response of a filter is constrained to be causal and designed in order to minimise the time averaged squared error between the filter output and the "desired" filter output. The governing equations which have to be satisfied to ensure an optimal design are easier to handle when working in discrete (rather than continuous) time and the least squares method has become a standard technique in digital filter design. Furthermore, the LMS algorithm of Widrow and Hoff [21 provides an efficient numerical technique for rapidly adapting the coefficients of an FIR digital filter to provide the optimal impulse response. In acoustics, this algorithm requires a further modification before it can be utilised. In the loudspeaker equalisation problem, for example, the output from the filter to be designed passes through the electroacoustic path between the loudspeaker input and the point in space at which equalisation is sought. This additional transfer function has to be accounted for when using the LMS algorithm and the appropriately modified version has become known as the "filtered-$x$" LMS algorithm as described by Widrow and Stearns [3]. The algorithm was first proposed by Morgan [4] and independently for use in feedforward control by Widrow [5] and for the active control of sound by Burgess [6]. In many problems involving the active control of sound and vibration it is often necessary to use multiple inputs and to ensure that the control filters are designed to ensure the minimisation of some appropriate measure of error at multiple points in space [7]. This requirement led Elliott and Nelson [8] to generalise the filtered-$x$ LMS algorithm to deal with multiple errors. The resulting algorithm has become known as the Multiple Error LMS algorithm [9] and it has been extensively utilised in a variety of applications involving the active control of sound and vibration (see Nelson and Elliott [10] for a full account).
The Multiple Error LMS algorithm has been still further generalised and specifically applied to problems in audio system equalisation by Nelson *et al* [11, 12]. In that work, the formulation of the problem was generalised to incorporate multiple input signals. This is the case found in stereophonic reproduction for example, where the algorithm has since been applied with considerable success [13]. The general formulation of the least squares filter design problem will again be presented here before describing further potential applications of the technique to the reproduction of sound.

### 1.2 Solution of the multi-channel problem

The multi-channel problem is illustrated in block diagram form in Figure 1. Working in discrete time, we have $K$ recorded signals $x_k(n)$ comprising the vector x($n$). These are transmitted via $M$ loudspeaker channels whose inputs are given by $y_m(n)$ which are the elements of the vector y($n$). The resulting signals are transmitted via a matrix C($z$) of electroacoustic transfer functions and detected by $L$ microphones whose outputs are given by $z_L(n)$, these being the elements of the vector $z(n)$. We introduce a $K \times M$ matrix H($z$) of FIR digital filters which operates on the $K$ recorded signals prior to transmission via the $M$ loudspeakers. The coefficients of the filters in the matrix are designed in order to minimise the weighted sum of the mean squared values of the error signals $e_l(n)$. The $l$th error signal is defined as the difference between the desired signal $d_l(n)$ and the reproduced signal $z_l(n)$. The desired signals $d_l(n)$ (comprising the vector d($n$)) are in turn specified by passing the recorded signals $x_k(n)$ through a $K \times L$ matrix A($z$) of filters. The filter matrix A($z$) thus specifies the desired signals. Whilst this is the most general method of specifying the desired signals, the elements of A($z$) will in general include appropriate "modelling delays" such that the desired signals are in some sense delayed versions of the recorded signals. This is dearly necessary if reductions in mean squared error are to be achieved when the elements of C($z$) are non-minimum phase. The way in which A($z$) may be specified will become clearer in the next section.

The problem of finding the optimal coefficients of the filters in H($z$) will now be addressed. As in the single channel case when developing the filtered-$x$ LMS algorithm, the analysis is greatly assisted by effective reversal of operation of the transfer functions H($z$) and C($z$). This leads to the definition of the "filtered reference signals" $r_{lmk}(n)$ which are the signals produced by passing $k$'th recorded signal through the $l,m$ th element of the matrix C($z$). Thus the signal $z_l(n)$ can be expressed as

$$z_l(n) = \sum_{k=1}^{K} \sum_{m=1}^{M} \sum_{i=0}^{I-1} h_{mk}(i)\, r_{lmk}(n-i) \tag{1}$$

where $h_{mk}(i)$ is the $i$'th coefficient of the FIR filter whose input is the $k$'th recorded signal and whose output is the input to the $m$'th loudspeaker. Each filter is assumed to have an impulse response of $I$ samples in duration. In vector notation we can write equation (1) as

$$z_l(n) = h^T(o)\, r_l(n) + h^T(1)\, r_l(n-1) \dots h^T(I-1)\, r_l(n-I+1) \tag{2}$$

where we have defined a composite tap weight vector and a reference signal vector respectively by

$$h^T(i) = [h_{11}(i)\ h_{21}(i)..h_{M_1}(i)\ |h_{12}(i)h_{22}(i)..h_{M_2}(i)|h_{1\,K}(i)H_{zK}(i)..h_{MK}(i)] \tag{3}$$

$$r_l^T(n) = [r_{l11}(n)\ r_{l21}(n)..r_{lm_1}(n)|r_{l2}(n)r_{l22}(n)..$$

$$..r_{lM2}(n)|r_{lK}(n)r_{l2\,K}(n)..r_{lMK}(n)] \tag{4}$$

A further composite tap weight vector can be defined which consists of all the $I$ tap weights of all the $L \times M$ filters. Thus is given by

$$w^T = [h^T(o)h^T(1)..h^T(I-1)] \tag{5}$$

The $L$'th order vector of error signals can now be written as

$$e(n) = R(n)w - d(n) \tag{6}$$

where the matrix R($n$) of filtered reference signals is given by

$$R(n) = \begin{bmatrix} r_1{}^T(n)\ r_1{}^T(n-1)\ \ldots\ r_1{}^T(n-l+1) \\ r_2{}^T(n)\ r_2{}^T(n-1)\ \ldots\ r_2{}^T(n-l+1) \\ \\ r_L{}^T(n)\ r_L{}^T(n-1)\ \ldots\ r_L{}^T(n-l+1) \end{bmatrix} \qquad (7)$$

With the vector of error signals defined by equation (6), we can now proceed to determine the optimal value of the composite tap weight vector w which minimises the sum of the squared error signals. Here we will generalise the problem somewhat by minimising a cost function which allows for differential weighting of the squared errors (which may be important in some applications) and also penalises the "effort" used in arriving at the optimal solution. The latter strategy may prove useful in the event of the problem becoming ill-conditioned, where little reduction in error is achieved at the expense of large values of the filter coefficients. Thus we define a cost function given by

$$J = E[e^T(n)\ W_e\ e(n) + w^T(n)\ W_w\ w(n)] \qquad (8)$$

where $W_e$ and $W_w$ are (generally diagonal) weighting matrices and $E[\ ]$ denotes the expectation operator. The minimum of this quadratic function can be found by first substituting the expression for e($n$) given by equation (6) and then setting the gradient of $J$ with respect to w equal to zero. Thus assuming $W_e$ is symmetric, $J$ can be written as

$$J = E[d^T(n)\ W_e\ d(n) - 2\ w^T R^T(n)\ W_e\ d(n) + w^T(R^T(n)\ W_e\ R(n) + W_w)w] \qquad (9)$$

The gradient of $J$ with respect to w, also assuming that $W_w$ is symmetric, can be written as

$$\frac{\partial J}{\partial w} = 2E[(R^T(n)\ W_e R(n) + W_w)w - R^T(n)\ W_e\ d(n)] \qquad (10)$$

Thus the solution that ensures that $\partial J/\partial w$ is zero is given by the optimal tap weight vector

$$w_0 = \{E[R^T(n)\ W_e\ R(n) + W_w]\}^{-1}\ \{E[R^T(n)\ W_e\ d(n)]\} \qquad (11)$$

The corresponding minimum value of $J$ is given by

$$J_0 = E[d^T(n)\ W_e\ d(n)] - E[d^T(n)\ W_e\ R(n)]w_0 \qquad (12)$$

The optimal tap weight vector $w_0$ can clearly be found by inversion of the matrix $E[R^T(n)\ W_e R(n) + W_w]$ which must be positive definite for a unique minimum to exist. In the case when $W_e = I$ (the identity matrix) and $W_w = 0$, this matrix has a block Toeplitz structure and efficient numerical schemes exist for its inversion [14]. The other approach is to use the Multiple Error LMS algorithm. This has its origin in the method of steepest descent in which the minimum of the function is found iteratively by updating the coefficient vector w by an amount proportional to the negative of the gradient of the function. First note that using equation (6) in equation (10) allows the gradient to be written as

$$\frac{\partial J}{\partial w} = 2E[R^T(n)\ W_e\ e(n) + W_w w] \qquad (13)$$

Following Widrow and Hoff [2], we now make the assumption that the filter coefficients are updated by an instantaneous estimate of this gradient, which is given by dropping the expectation operator in equation (13). Thus the tap weight update equation becomes

$$w(n+1) = w(n) - \alpha\ W_w w(n) - \alpha\ R^T(n)\ W_e\ e(n) \qquad (14)$$

where $\alpha$ is a convergence coefficient. Equation (14) thus specifies a simple and readily implemented algorithm for iteratively converging to the solution for the optimal coefficient vector. As pointed out by Elliott *et al* [9], the effect of the "effort" weighting $W_w$ can be shown to be equivalent to the "leaky" LMS algorithm in which case in the absence of an error term $e(n)$, the coefficient vector w would decay away to zero. Note that the implementation of the algorithm requires the generation of the filtered reference signals $r_{lmk}(n)$ which comprise the elements of the matrix R(n). These can be generated by passing the recorded signals $x_k(n)$ through FIR filters which give an estimate of the transfer function $C_{lm}(z)$. These in turn can be identified by using a broadband training signal passed through the $m$'th loudspeaker to the $l$'th microphone with the LMS algorithm used to adapt the filter coefficients.

## 1.3 Relationship of the least squares solution to methods for finding exact inverse filters

An alternative approach to inverse filtering in room acoustics is that proposed by Myoshi and Kaneda [15] in the form of the Multiple-Input/Output Inverse Filtering Theorem (MINT). In that work, it is demonstrated that a pair of filters can be designed which can be used on the inputs to two loudspeakers which are both used to transmit a given recorded signal to a specific point in space. The filters can be designed to ensure that "perfect" equalisation of the transmission path is produced, even when the transmission paths between the loudspeaker inputs and the point where equalisation is required are non-minimum phase (after an appropriate bulk delay has been subtracted; a point which is not altogether dear from Myoshi and Kaneda's paper [15]). An analysis of the relationship between MINT and the least squares approach presented above has been presented by Nelson *et al* [16]. This leads to a useful result which may have some bearing on the choice of the values of $K$, $M$ and $L$ in a given application, together with number of coefficients $I$ used in the inverse filters.

It is assumed at the outset that the transmission paths $C_{lm}(z)$ can be adequately represented by FIR filters having $I$ coefficients. It can then be shown that to produce exact equalisation of the transmission channels from $K$ recorded signals to $L = K$ points in space requires that the number of coefficients in the inverse filters is given by

$$I = (J - 1)\left(\frac{L}{M - L}\right) \tag{15}$$

The full derivation leading to this result is presented in reference [16]. However, it should again be emphasised that the choice of $I$ given by equation (15) ensures the exact equalisation of the J-coefficient FIR filters representing the transmission paths $C_{lm}(z)$; equalisation of the *real* transmission paths therefore assumes that all these paths are exactly represented by $J$-coefficient filters. Nevertheless, the analysis presented in reference [16] gives some indication of the number of coefficients $I$ required in the inverse filters and demonstrates furthermore that in order to realise an exact inverse, it is required that $M > L$ (i.e. a greater number of loudspeakers is required than the number of points at which equalisation is attempted). This result is therefore consistent with the work of Myoshi and Kaneda [15] who show, for example, in the case $M = 2$, $L = 1$, that $I = (J - 1)$. The work presented in reference [16] generalises Myoshi and Kaneda's result and also suggests that the Multiple Error LMS algorithm can be used to find the required solution for the coefficients of the inverse filters.

## BRIEF DESCRIPTION OF THE DRAWINGS

Figure 1 is a block diagram for the analysis of multi-channel inverse filtering problems in sound reproduction,

Figure 2 shows a geometrical arrangement of real sources (S1, S2) whose outputs are prefiltered in accordance with the invention in order to produce signals at microphones (M1, M2) which appear to originate from virtual sources (V1, V2).

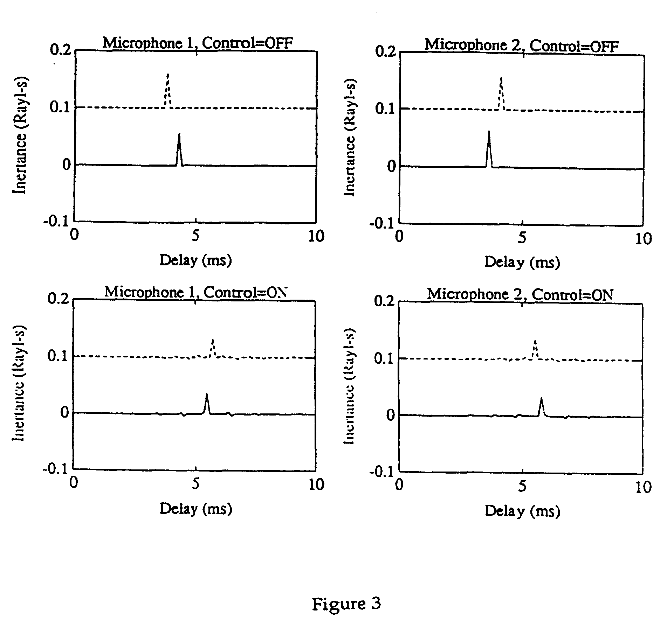

Figure 3 shows the impulse responses from inputs $x_1$ (dashed line) and $x_2$ (solid line) to the two microphones shown in Figure 2 before (Control = OFF) and after (Control = ON) the introduction of the filter matrix **H** used to pre-filter the outputs of sources S1 and 52. The relative arrival times of the impulses at the microphones are as if they originated from virtual sources V1 and V2. A modelling delay of 6.25 ms included during the simulations has been removed from the prefiltered responses (lower plots).

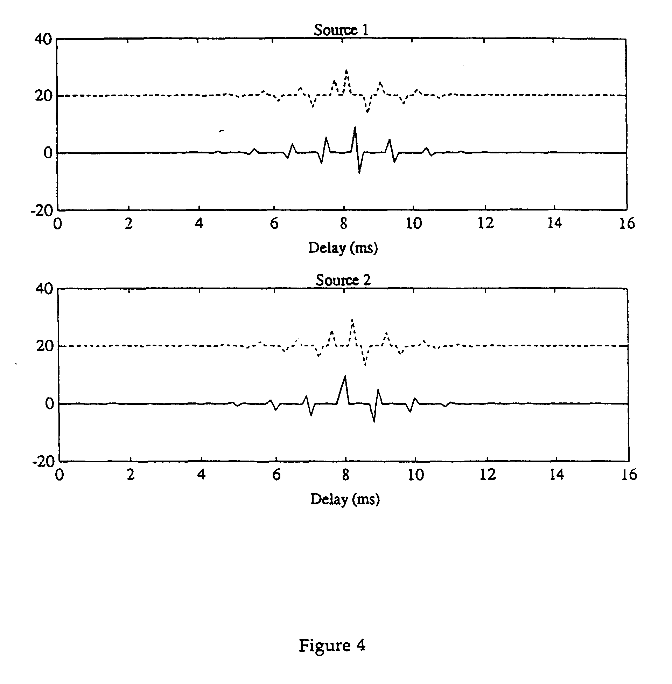

Figure 4 shows the impulse responses of the elements of the filter matrix **H** designed to pre-filter the outputs of sources S1 and S2 shown in Figure 2. The dashed lines show the impulse responses of the filters operating on input $x_1$ and the solid lines show the impulse responses of the filters operating on input $x_2$.

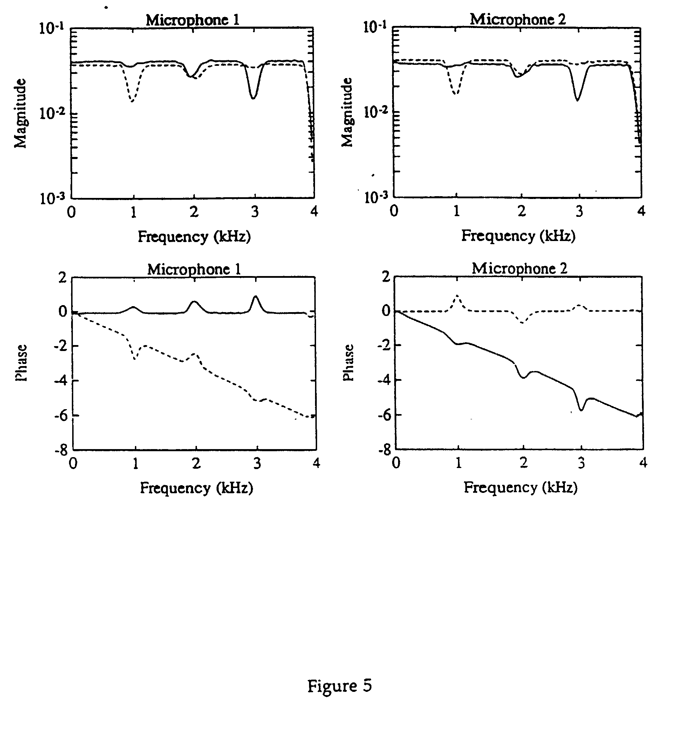

Figure 5 shows frequency response functions associated with the composite system **H**(z)**C**(z) whose impulse response is illustrated in the lower traces of Figure 3. The phase responses have been calculated relative to that associated with the first arrival in the time domain. Note the small difference in magnitude response and the substantial difference in phase response corresponds to that which would be expected to be produced by the virtual source locations shown in Figure 2.

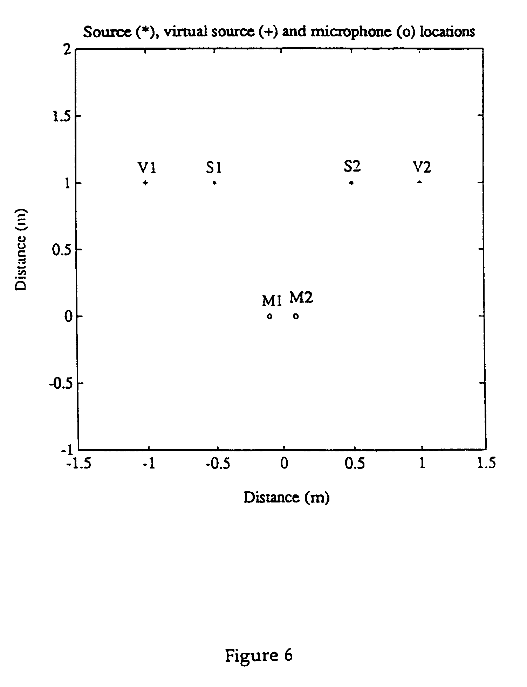

Figure 6 shows a further geometrical arrangement of real sources (S1, S2) whose outputs are prefiltered in accordance with the invention in order to produce signals at microphones (M1, M2) which appear to originate from virtual sources (V1, V2).

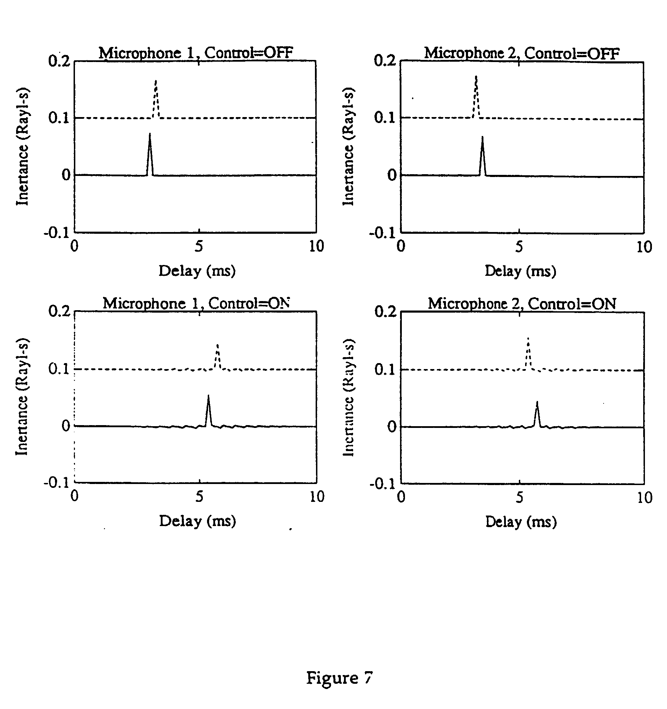

Figure 7 shows impulse responses from inputs $x_1$ (dashed line) and $x_2$ (solid line) to the two microphones shown in Figure 6 before (Control = OFF) and after (Control = ON) the introduction of the filter matrix **H** used to prefilter the outputs of sources S1 and S2. Note the increased time between the arrivals of the impulses produced by the location of the virtual sources V1 and V2.

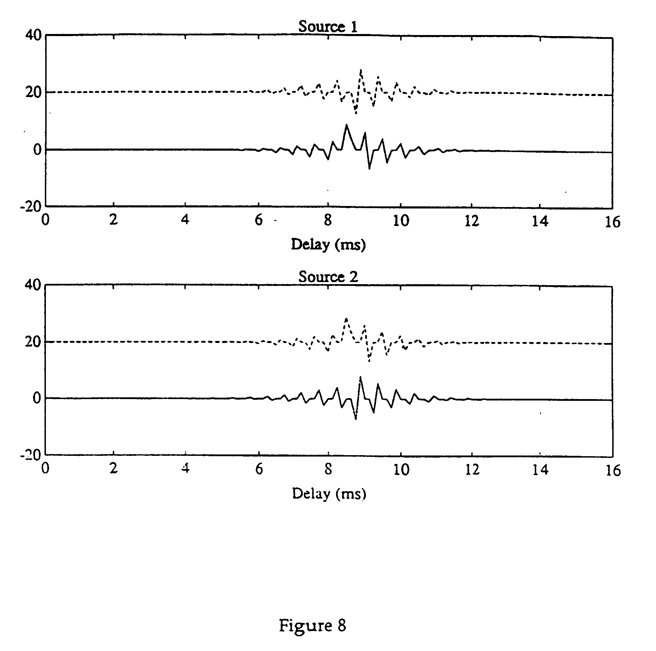

Figure 8 shows impulse responses of the elements of the filter matrix H designed to pre-filter the outputs of sources S1 and S2 shown in Figure 6. The dashed lines show the impulse responses of the filters operating on input $x_1$ and the solid lines show the impulse response of the filters operating on input $x_2$.

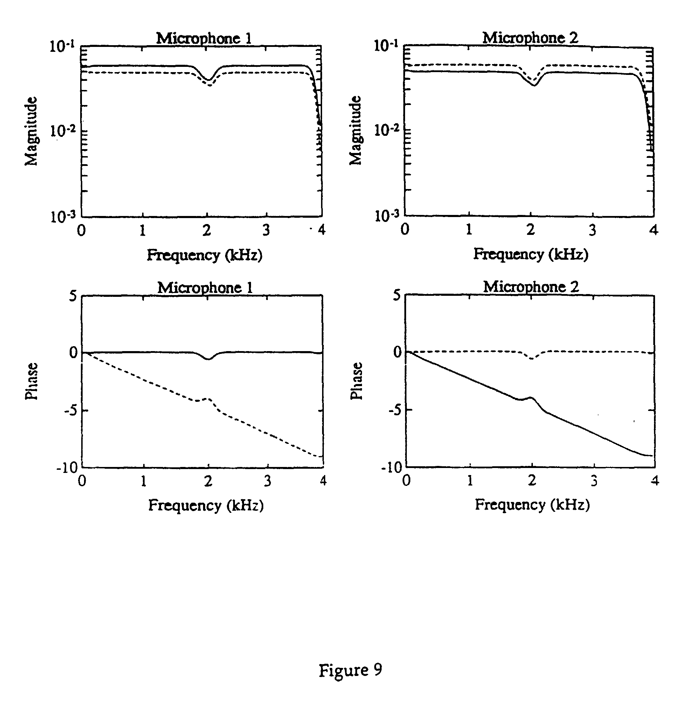

Figure 9 shows frequency response functions associated with the composite system $\mathbf{H}(z)\mathbf{C}(z)$ whose impulse response is illustrated in the lower traces of Figure 7. The phase responses have been calculated relative to that associated with the first arrival in the time domain. Note the small difference in magnitude response and the substantial difference in phase response corresponds to that which would be expected to be produced by the virtual source locations shown in Figure 6.

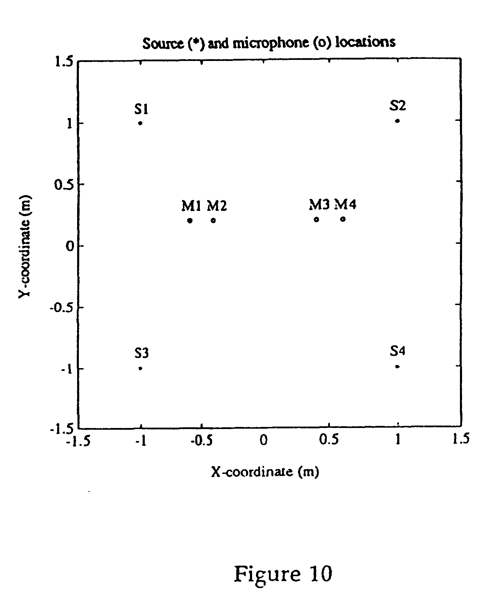

Figure 10 shows a source and microphone layout used in simulating the production of multiple stereo images. The two signals $x_1$ and $x_2$ are filtered in accordance with the invention with a matrix $\mathbf{H}(z)$ prior to transmission via sources S1 - S4.

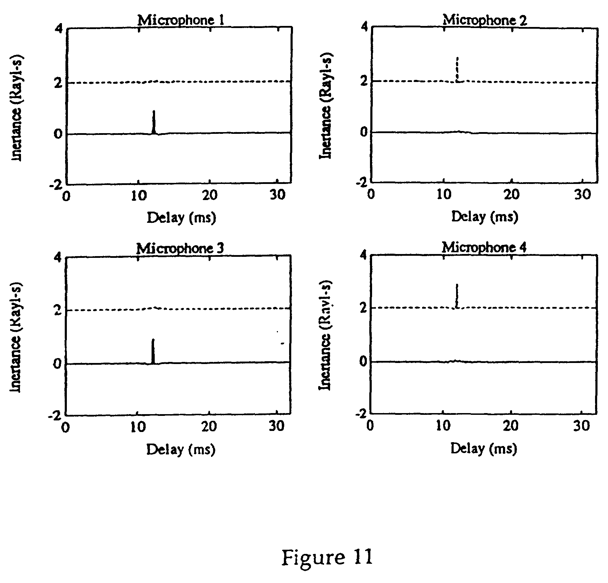

Figure 11 shows impulse responses of the composite system $\mathbf{H}(z)\mathbf{C}(z)$ for inputs $x_1$ (solid line) and $x_2$ (dashed line) when $\mathbf{H}(z)$ is designed to ensure that $x_1$ is reproduced at microphones M1 and M3 and that $x_2$ is reproduced at microphones M2 and M4 (see Figure 10).

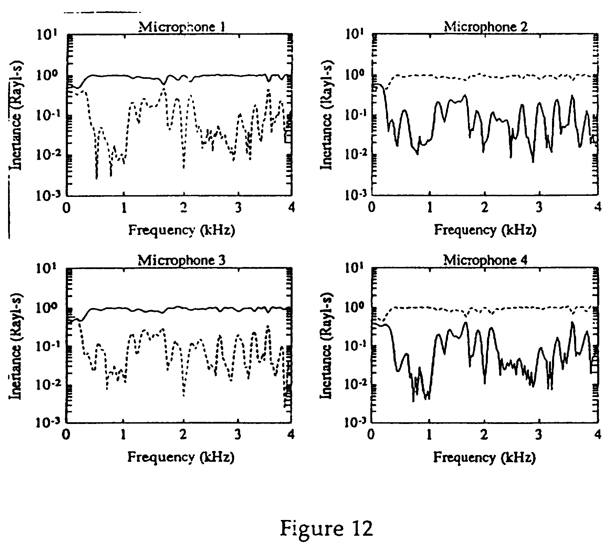

Figure 12 shows frequency response functions corresponding to the impulse responses of Figure 11.

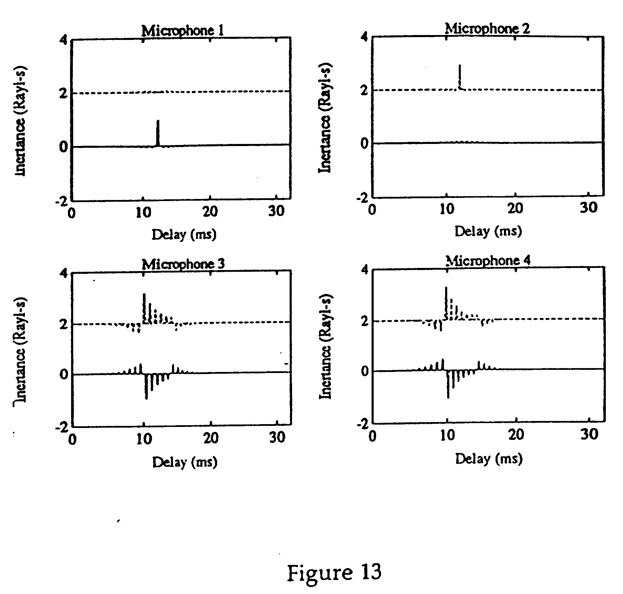

Figure 13 shows the impulse response of the composite system $\mathbf{H}(z)\mathbf{C}(z)$ when $x_1$ (solid line) and $x_2$ (dashed line) are filtered by a 2 x 2 matrix $\mathbf{H}(z)$ prior to transmission via sources S1 and S2 in Figure 10. $\mathbf{H}(z)$ is designed to ensure that $x_1$ and $x_2$ are reproduced at M1 and M2 respectively. Note the degradation of the response at M3 and M4.

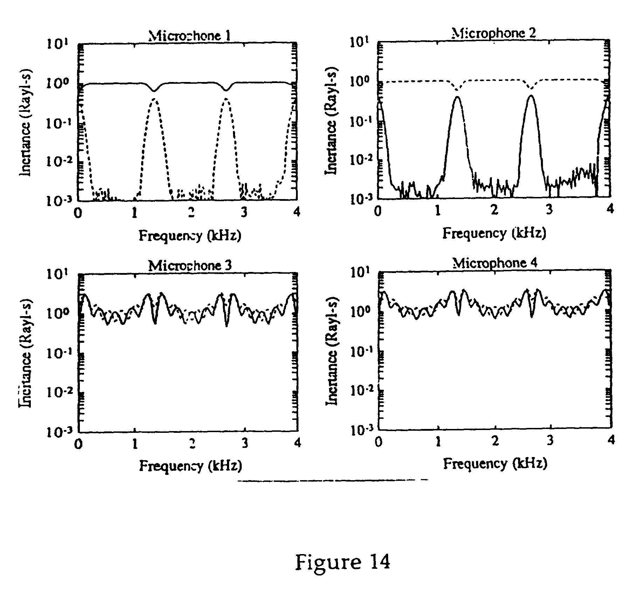

Figure 14 shows frequency response functions corresponding to the impulse responses of Figure 13.

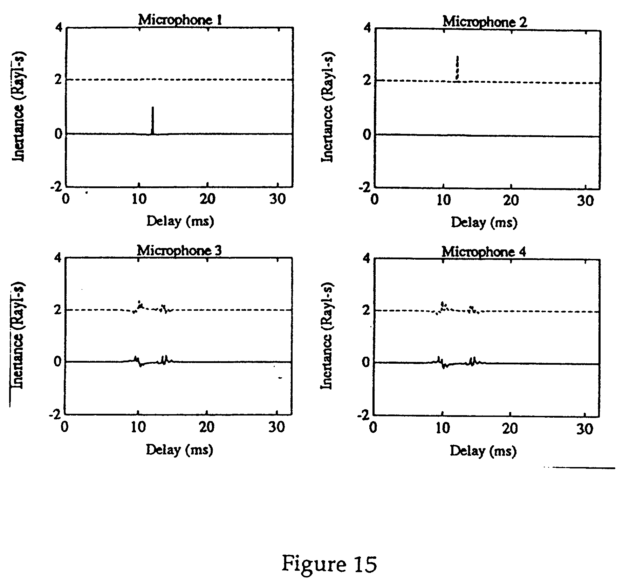

Figure 15 shows impulse responses of the composite system $\mathbf{H}(z)\mathbf{C}(z)$ when $x_1$ (solid line) and $x_2$ (dashed line) are filtered by a 4 x 2 matrix $\mathbf{H}(z)$ prior to transmission via all four sources in Figure 10. $\mathbf{H}(z)$ is designed to ensure that $x_1$ and $x_2$ are reproduced at M1 and M2 respectively.

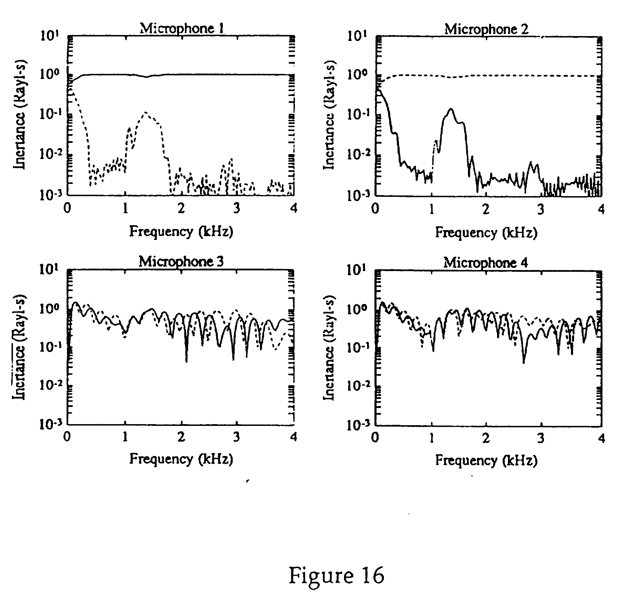

Figure 16 shows frequency response functions corresponding to the impulse responses of Figure 15. Note the improvement in cross talk cancellation at M1 and M2 compared to the results of Figure 14.

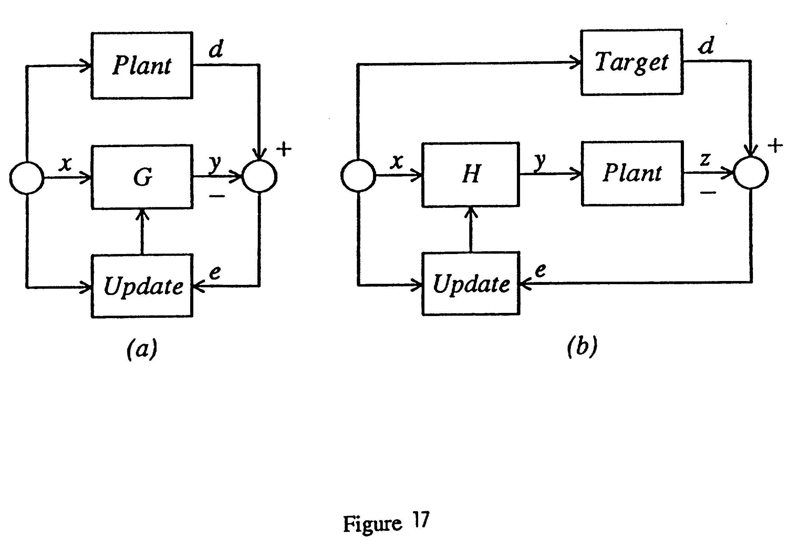

Figure 17 shows at (a) a block diagram for the adaptive system identification problem. The filter **G** must be adapted so that its output approximates the output from the plant, and at (b) a block diagram for the adaptive system equalization problem. The filter **H** must be adapted so that the output from the plant approximates the output of a given target system which, in general, includes a modelling delay that ensures the existence of a causal optimal filter.

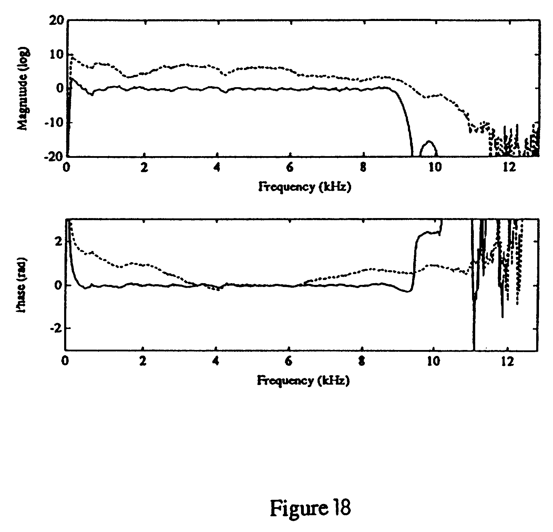

Figure 18 shows the frequency response function of a loudspeaker in an anechoic chamber. Unequalized (dashed line) and equalized using in accordance with the invention the sparse update adaptive algorithms (solid line).

## 2. POTENTIAL APPLICATIONS OF MULTI-CHANNEL TECHNIQUES IN THE IMPROVEMENT OF SOUND REPRODUCTION SYSTEMS

### 2.1 The use of multiple errors in single channel response equalisation

Of course the simplest equalisation problem corresponds to the case where an inverse filter is introduced on the input to a loudspeaker and the filter is designed to ensure that the signal reproduced at a point in space is as near as possible (in the least squares sense) to a delayed version of the input signal. A simple example of such an approach is that presented by Kuriyama and Furukawa [17] who use the single channel filtered-x LMS algorithm to design a filter for the equalisation of the on-axis response of a three-driver loudspeaker system (including cross-over networks). A 512 coefficient FIR filter operating at a sample rate of 32 kHz succeeded in producing a flat amplitude and linear phase response between 200 Hz and 12 kHz. No results were reported however, of measurements of the response of the system at spatial positions other than those at which equalisation was achieved. This is a crucial issue in response equalisation problems; the effect of the equalising filter on the global performance of the system. This problem has been addressed by Wilson [18] in the context of loudspeaker equalisation. It was demonstrated that minimising a weighted sum of squared errors derived from measurements of both on- and off-axis responses was successful in improving the off-axis response also, albeit at the expense of the improvements in on-axis response. Similar comments apply to room response equalisation. Farnsworth *et al* [19], for example, used computer simulations of an enclosed sound field to investigate the effect of equalising the transmission response to one point in a room on the responses at other points in the room. The results predicted a potentially severe degradation of response outside a zone surrounding the equalisation points. The subjective response to this effect, however, has yet to be quantified. An attempt to ensure "global equalisation" was made by Elliott and Nelson [20] who also used computer simulations to study the equalisation of the low frequency acoustic field in a car interior. In that case, multiple errors were again minimised, with the desired signals being specified at a number of points in the sound field. These desired signals were delayed versions of the input signal with the delays chosen to be equal to the acoustic propagation delays from the simulated loudspeaker source to the points at which the desired signals were specified. This strategy predicted "global equalisation" in the sense that the frequency response was improved at all the equalisation points, but of course was not made perfect at any one point.

## 2.2 Response equalisation in stereophonic reproduction

Rather than attempting (the unrealisable) goal of perfect global equalisation of a single channel system (which is then subsequently used in a stereophonic reproduction system), a more realistic approach may be to accept from the outset that good equalisation may be achieved in restricted spatial zones and then to design equalisation systems that make maximum use of this capability. Also accepting that modern sound reproduction systems almost exclusively involve the transmission of two channels of recorded signal leads to some further specific applications of equalisation techniques. One such application is described in detail by Nelson *et al* [13] where a 2 x2 matrix of filters H(z) was used to process two recorded signals prior to transmission via two loudspeakers. The desired signals were specified at two points in space, these being at the location of the ears of a human listener. These desired signals were specified as simply delayed versions of the "left" and "right" channels respectively. Thus once the equalisation filters had been adapted, the left ear of the listener would perceive only the recorded signal from the left channel and the right ear would perceive only the recorded signal from the right channel. The inverse filter was thus effective in cancelling the "crosstalk" between left loudspeaker and right ear and vice-versa, in addition to equalising the frequency responses of both loudspeakers. As such, the system represents a digital implementation of the system suggested by Atal and Schroeder [21], the impressive subjective capabilities of the original analogue implementation being graphically described by Schroeder [22]. Such a system is well suited to the reproduction of binaurally recorded sound fields, such as those recorded with the use of an artificial head.

However, most modern recordings do not use such techniques and the typical two-channel stereophonic recording is a carefully mixed amalgam of individual signals, with left and right channels attributed with signal components in order to maximise the effective stereophonic illusion, largely in accordance with the subjective judgements of the producer of the recording. If one accepts that such recording techniques will not readily be changed, the potential for the further exploitation of equalisation techniques becomes focussed on providing realisable improvements in existing reproduction systems. One such improvement that can be obtained in accordance with the invention is to use adaptive filters to compensate for practical deficiencies in loudspeaker *location* relative to a listener. In the case of in-car entertainment systems for example, it is very difficult to locate the loudspeakers symmetrically with respect to the listener and thus produce the stereophonic illusion initially perceived by the recording engineer. The same may be true of many domestic listening environments. With appropriately designed filters, however, the loudspeakers can effectively be shifted to "virtual locations" which apparently seat the listener in the optimal location.

The geometry used in computer simulations of this approach in accordance with the first aspect of the invention is shown in Figure 2. The matrix C(z) which relates the signals output from sources S1 and S2 to microphones $M_1$ and $M_2$ (placed at the location of the listeners ears) is given by

$$C(z) = \frac{\rho_o}{4\pi} \begin{bmatrix} \dfrac{z^{-\Delta_{11}}}{r_{11}} & \dfrac{z^{-\Delta_{12}}}{r_{12}} \\[2em] \dfrac{z^{-\Delta_{21}}}{r_{21}} & \dfrac{z^{-\Delta_{22}}}{r_{22}} \end{bmatrix} \qquad (16)$$

where these transfer functions are the digital versions of the continuous time transfer function relating the pressure at a point in space to the volume acceleration of a point monopole source. Thus the delays $\Delta_{ml}$ are given by

$$\Delta_{ml} = \text{round}\ (f_s\ r_{ml}/c_o) \qquad (17)$$

where $r_{ml}$ is the distance between the $m$'th source and the $l$th microphone, $f_s$ is the sampling frequency and $c_o$ is the sound speed. The matrix A($z$), which specifies the relationship between the recorded signals and the desired signals, is selected by assuming that we have certain "virtual source" locations V1 and V2, as illustrated in Figure 2. This ensures that the desired signals $d_1(n)$ and $d_2(n)$ are those that would be produced by sources $V1$ and $V2$. Thus

$$A(z) = \frac{\rho_o z^{-\Delta mod}}{4\pi} \begin{bmatrix} \dfrac{z^{-\gamma_{11}}}{u_{11}} & \dfrac{z^{-\gamma_{12}}}{u_{12}} \\[2mm] \dfrac{z^{-\gamma_{21}}}{u_{21}} & \dfrac{z^{-\gamma_{22}}}{u_{22}} \end{bmatrix} \qquad (18)$$

where $z^{-\Delta}mod$ is a modelling delay and the delays $\gamma_{ml}$ are given by

$$\gamma_{ml} = \text{round}(f_s\, u_{ml}/c_o) \qquad (19)$$

where $u_{ml}$ is the distance between the $m$'th virtual source location and the $l$th microphone. In all the simulations that follow, the sample rate $f_s$ was chosen to be 8 KHz with $c_o = 341$ ms$^{-1}$ and $\rho_o = 1.0$ kg/m$^3$ for simplicity. The number of coefficients I in the filter matrix H($z$) was always chosen to be 128, and the filters were designed adaptively using pseudo-random sequences $x_1(n)$ and $x_2(n)$.

In the arrangement shown in Figure 2, for the purposes of illustration, the sources $S1$ and $S2$ are not only placed asymmetrically with respect to $V1$ and $V2$ but are also *inverted* relative to V1 and V2. Figure 3 shows the resulting impulse response of the system once the filter matrix H($z$) has been designed using the algorithm of equation (14) with $W_w = 0$ and $W_e = I$. The corresponding filter impulse responses are illustrated in Figure 4. The results of Figure 3 clearly demonstrate that once signals input to $S1$ and $S2$ are prefiltered by H($z$) (control = ON in the figures) the relative time of arrival of impulses input to the system become equivalent to those that would be produced by virtual sources $V1$ and $V2$. Note that for microphone 1 for example, the signal from $S2$ arrives *after* that from $S1$ whilst for microphone 2, the signal from $S2$ arrives *before* that from $S1$; a situation which reverses that observed in the unfiltered case (Control = OFF in the figure). The effectiveness of the system is also illustrated by the frequency response plots shown in Figure 5. These in particular show how the relative phase between the signals arriving at microphones 1 and 2 indicates the difference in travel time between the virtual sources and the two microphones. Also note that the magnitude responses are consistent with the difference in distance between the virtual sources and the microphones. Of course in this simple illustration, no reverberation is included in the model and this could also be accounted for in the implementation of a real system.

In accordance with a second aspect of the invention such a technique could also find application in listening systems where the loudspeakers for reproduction are placed close together; the virtual sources could be placed in order to effectively increase the spacing between the real sources. Figures 7, 8 and 9 show the results of simulations which indicate the feasibility of this approach with the geometry of the real and virtual sources illustrated in Figure 6. Figure 7 shows how the arrival times of impulses applied via the signals $x_1(n)$ and $x_2(n)$ are made different by the presence of the filter matrix H($z$). In particular, the time between arrivals at a given microphone is increased to be consistent with the location of the virtual sources. The impulse responses of the filters necessary to accomplish this are shown in Figure 8, and Figure 9 shows the frequency response functions of the composite system H($z$)C($z$). These again illustrate the magnitude and phase differences associated with the specified virtual source locations.

### 2.3 The production of multiple stereophonic images

In accordance with a third aspect of the invention yet another possibility that emerges from the general filter design philosophy outlined above, is that of operating on the two channels of a conventional stereophonic recording in order to produce ideal virtual source locations for *two* independent listening positions. Such an approach does however require the use of at least *four* loudspeakers. As an illustration of this possibility, here we present the results of some computer simulations (first presented by Orduna-Bustamante *et al* [23]) where the source/microphone arrangement of Figure 10 is considered. Also, for the purposes of illustration, we will deal with the "cross-talk cancellation" case where, for example, we wish to reproduce two recorded signals $x_1(n)$ and $x_2(n)$ at $M1$ and $M2$ *and* at $M3$ and $M4$. In this case, the matrix C($z$) takes the form

$$C(z) = \frac{\rho_0}{4\pi} \begin{bmatrix} (z^{-\Delta 11}/r_{11}) & (z^{-\Delta 12}/r_{12}) & (z^{-\Delta 13}/r_{13}) & (z^{-\Delta 14}/r_{14}) \\ (z^{-\Delta 21}/r_{21}) & (z^{-\Delta 22}/r_{22}) & (z^{-\Delta 23}/r_{23}) & (z^{-\Delta 24}/r_{24}) \\ (z^{-\Delta 31}/r_{31}) & (z^{-\Delta 32}/r_{32}) & (z^{-\Delta 33}/r_{33}) & (z^{-\Delta 34}/r_{34}) \\ (z^{-\Delta 41}/r_{41}) & (z^{-\Delta 42}/r_{42}) & (z^{-\Delta 43}/r_{43}) & (z^{-\Delta 44}/r_{44}) \end{bmatrix} \qquad (20)$$

and the matrix A(z) which defines the desired signals is given by

$$A(z) = z^{-\Delta_{mod}} \begin{bmatrix} 1 & 0 \\ 0 & 1 \\ 1 & 0 \\ 0 & 1 \end{bmatrix} \qquad (21)$$

where $\Delta_{mod}$ is a modelling delay. In the simulations presented here, the 4 × 2 matrix H(z) was comprised of eight FIR filters each having a number of coefficients $I = 128$. The modelling delay $\Delta_{mod}$ was chosen to be 96 samples.

The resulting impulse responses of the system consisting of H(z) C(z) are illustrated in Figure 11 and the corresponding frequency response functions are shown in Figure 12. A good degree of cross-talk cancellation is dearly evident, although the system becomes less effective at certain frequencies where the inverse filters have difficulty in modelling what amount to poles of the inverse system (see Nelson *et al* [13] for a fuller discussion). The use of IIR filters may provide a solution to this problem and a preliminary investigation is reported in reference [24]. The use of IIR filters in the single channel case has also been examined by Greenfield and Hawksford [25]. This problem is more clearly illustrated in the simple case of the reproduction of signals $x_1(n)$ and $x_2(n)$ at $M1$ and $M2$ respectively. The results of implementing such a system are illustrated in Figures 13 and 14. Effective cross-talk cancellation is produced (except at certain frequencies) at microphones 1 and 2, whereas the signals at microphones 3 and 4 are dearly degraded by the operation of the system, as one would expect. Finally, the potential advantages in using more sources than microphones in the sense described in Section 2.3 is illustrated by the results presented in Figures 15 and 16. Here, the 4 × 2 matrix H(z) has been designed to ensure reproduction of $x_1(n)$ and $x_2(n)$ at microphones 1 and 2. Considerably improved cross-talk cancellation can be seen to have been achieved.

## SPARSELY UPDATED FILTERS FOR ADAPTIVE DIGITAL PROCESSING OF AUDIO SIGNALS

A sparse update strategy will now be described that allows the implementation of adaptive filters at high sampling rates using existing DSP technology. This technique has the important property that the processing time per sampling period spent in filter update operations is independent of the filter length. Code will be given for both the LMS and the filtered-x LMS algorithms and description of their practical use for loudspeaker equalisation.

## INTRODUCTION.

The single-channel system identification problem is shown in Figure 17(a). A vector containing the $L$ most recent samples of the input signal is defined as

$$x_n = [x_n \, x_{n-1} \, ... \, x_{n-L+1}]^T;$$

similarly, a vector containing the coefficients of a (non-stationary) non-recursive digital filter is defined as

$$g_n = [g_0(n) \, g_1(n) \, ... \, g_{L-1}(n)]^T.$$

The dot product of the input vector with the coefficient vector produces the output

$$y_n = g_n^T x_n.$$

This is required to approximate the desired signal $d_n$ (the output from the system under identification), in a way that minimizes the variance of the error signal defined by

$$e_n = d_n - y_n.$$

The LMS algorithm [3] performs a stochastic gradient search in $L$-dimensions according to the formula

$$g_{n+1} = g_n + \mu e_n x_n$$

which can be shown to converge on the mean to the exact least mean squares solution of the problem provided the adaptation rate is chosen to satisfy the following condition

$$\mu < 1/L\sigma_x^2$$

The implementation of this algorithm in a microprocessor requires $4L$ arithmetic operations ($2L$ to perform the filtering and $2L$ to update the filter). At high sampling rates this can prove very taxing and heavy restrictions must be imposed on the number of coefficients.

The system equalization problem is shown in Figure 17(b). In this case, a new filter with coefficients

$$h_n = [\, h_0(n) \; h_1(n) \, ... \, h_{L-1}(n) \,]^T$$

acts on the input signal to produce the signal

$$y_n = h_n^T x_n$$

which after transmission through the system produces an output $z_n$ that minimizes the variance of a new error signal defined as

$$e_n = d_n - z_n.$$

The coefficients of the optimal filter can be searched using the fiitered-$x$ LMS algorithm [9]

$$h_{n+1} = h_n + \mu e_n r_n;$$

where the vector $r_n$, containing recent samples of the reference signal

$$r_n = g^T x_n,$$

is used instead of the vector of input signals as in the LMS algorithm. This increases the arithmetic work by another $2L$ operations (assuming that both filters g and h have the same length). The arithmetic work thus increases to $6L$ operations.

## SPARSE UPDATE IMPLEMENTATION OF THE LMS ALGORITHM.

One way of reducing the operation count required to update the filter coefficients using the LMS algorithm is to devise a criterion to select the absolute minimum number of operations that are still necessary to maintain the convergence properties of the algorithm. The minimum work that can be done is to update only one filter coefficient per sampling period. This can be implemented by performing the following operations at every processing cycle $n$

$$g_k(n) = g_k(n) + \mu e_n x_{n-k}, \qquad \text{(update current filter tap)}$$
$$k = (k + 1) \bmod L; \qquad \text{(increment tap counter)}$$

where $k$ is a counter set initally to $k=0$ that runs circularly along the vector of filter coefficients. Note that because $n$ and $k$ are always incremented by 1 every cycle (except when $k$ wraps around to zero), the input sample that is used for the update $x_{k-n}$ is exactly the same during the $L$ cycles that it takes to perform one pass along the whole filter. This observation leads to the following alternative, but exactly equivalent, version of the sparse update version of the LMS algorithm

$$\text{if } k = 0 \text{ then } \alpha = \mu x_n \qquad \text{(store, and pre-multiply, input sample)}$$
$$g_k(n) = g_k(n) + \alpha e_n \qquad \text{(update current filter tap)}$$
$$k = (k + 1) \bmod L \qquad \text{(increment tap counter)}$$

By following any of these procedures, it takes $L$ processing cycles to update the whole filter, but the operation count is reduced to $2L$ (basically those involved in the actual filtering).

## SPARSE UPDATE IMPLEMENTATION OF THE FILTERED-X LMS ALGORITHM.

A sparse update implementation of the filtered-$x$ LMS algorithm presents the additional challenge of having to calculate the filtered reference signal in a way which is compatible with the sparse update of the filter coefficients. Interestingly enough the calculation of the filtered reference signal can be performed also on a single-tap basis as follows

$$\text{if } k=0 \text{ then } r=0 \qquad \text{(clear fltered-}x \text{ accumulator)}$$
$$r=r+g_{L-k-1}x_n \qquad \text{(accumulate current product)}$$
$$\text{if } k = L - 1 \text{ then } \alpha = \mu r \qquad \text{(when done, store filtered-}x\text{)}$$
$$k = (k + 1) \bmod L \qquad \text{(increment tap counter)}$$
$$h_k(n) = h_k(n) + \alpha e_n \qquad \text{(update current filter tap)}$$

Note that the calculation of the next sample of the filtered reference signal starts $L$ cycles in advance. To this end, the coefficients of the reference filter g are accessed in reverse, as shown, and the filtering makes use of the most recent input sample at every cycle (which, as it were, gets old by itself as times goes by). The operation count reduces again to just over $2L$ as in the sparse update implementation of the LMS algorithm.

## LOUDSPEAKER EQUALIZATION USING SPARSE UPDATE ADAPTIVE FILTERS.

Figure 18 shows the frequency response function of a loudspeaker in an anechoic chamber equalized to obtain a flat magnitude response and a linear phase response. The processing was performed in floating point arithmetic using a Texas Instruments TMS320C30 processor. The sampling frequency was set to $f=32$ kHz and the filter length to $L=48$. The impulse response function of the system was first identified using the sparse update version of the LMS algorithm. The system was later equalized using the sparse update implementation of the filtered-$x$ LMS algorithm. (A full update could only be possible at $f=16$kHz or $L=24$.)

## REFERENCES

1. Wiener, N. (1949). *Extrapolation, Interpolation and Smoothing of Stationary Time Series.* John Wiley, New York.

2. Widrow, B. and Hoff, M. (1960). Adaptive switching circuits. *Proceedings IRE WESCON Convention Record,* Part 4, Session 16, pp. 96-104.

3. Widrow, B. and Stearns, S.D. (1985). *Adaptive Signal Processing.* Prentice Hall, Englewood Cliffs, New Jersey.

4. Morgan, D.R. (1980). An analysis of multiple correlation cancellation loops with a filter in the auxiliary path. *Institute of Electrical and Electronics Engineers Transactions on Acoustics, Speech and Signal Processing* ASSP-28, 454-467.

5. Widrow, B., Shur, D. and Shaffer, S. (1981). On adaptive inverse control. *Proceedings of the 15th ASILOMAR Conference on Circuits, Systems and Computers,* pp. 185-195.

6. Burgess, J.C. (1981). Active adaptive sound control in a duct: a computer simulation. Journal *of the Acoustical Society of America* 70, 715-7626.

7. Nelson, P.A., Curtis, A.R.D. and Elliott, S.J. (1985). Quadratic optimisation problems in the active control of free and enclosed sound fields. *Proceedings of the Institute of Acoustics* 7, 45-53.

8. Elliott, S.J. and Nelson, P.A. (1985a). Algorithm for multi-channel LMS adaptive filtering. *Electronics letters* 21, 979-981.

9. Elliott, S.J., Stothers, I.M. and Nelson, P.A. (1987a). A multiple error LMS algorithm and its application to the active control of sound and vibration. *Institute of Electrical and Electronics Engineers Transactions on Acoustics Speech and Signal Processing* ASSP-35, 1423-1434.

10. Nelson, P.A. and Elliott, S.J. (1992). *Active Control of Sound.* Academic Press, London.

11. Nelson, P.A. and Elliott, S.J. and Stothers, LM. (1988). Improvements in or relating to sound reproduction systems. *International Patent Application PCT/GB89/00773.*

12. Nelson, P.A. and Elliott, S.J. (1988). Least squares approximations to exact multiple point sound reproduction. *Proceedings of the Institute of Acoustics* 10, 151-168.

13. Nelson, P.A., Harmada, H. and Elliott, S.J. (1992). Adaptive inverse filters for stereophonic sound reproduction. *Institute of Electrical and Electronics Engineers Transactions on Signal Processing* Vol.40, No. 7.

14. Robinson, E.A. (1978). Multi-channel *Time Series Analysis with Digital Computer Programs* (revised edition). Holden Day, San Francisco.

15. Miyoshi, M. and Kaneda, Y. (1988a). Inverse filtering of room acoustics. *Institute* of *Electrical and Electronics Engineers Transactions* on *Acoustics, Speech and Signal Processing* ASSP-36, 145-152.

16. Nelson, P.A., Hamada, H. and Elliott, S.J. (1991a). Inverse filters for multi-channel sound reproduction. Paper presented to the *Japanese Institute of Electronics, Information and Communication Engineers,* April 1991, Tokyo Denki University.

17. Kuriyama, J. and Furukawa, Y. (1988). Adaptive loudspeaker system. Paper presented at the *85th Convention of the Audio Engineering Society,* Los Angeles.

18. Wilson, R. (1989). Equalization of loudspeaker drive units considering both on-and off-axis responses. Paper presented at the *86th Convention of the Audio Engineering Society,* Hamburg.

19. Farnsworth, K.D., Nelson, P.A, and Elliott, S.J. (1985). Equalisation of room acoustic responses are spatially distributed regions. *Proceedings of the Institute of Acoustics Autumn Conference, Reproduced Sound,* Windermere.

20. Elliott, S.J. and Nelson, P.A. (1988). Multiple point least squares equalisation in a room using adaptive digital filters. *Journal of the Audio Engineering Society* 37, 899-907.

21. Atal, B.S. and Schroeder, M.R. (1962). Apparent sound source translator. US *Patent 3 236 949.*

22. Schroeder, M.R. (1975). Models of hearing. Proceedings of the IEEE, 63 1332-1352.

23. Orduna-Bustamante, F., Nelson, P.A., Hamada, H. and Uto, S. (1992). Computer simulation of a stereo sound reproduction system with adaptive cross-talk cancellation. *Proceedings of the first international conference on*

*motion and vibration control,* Yokohama, Japan.

24. Nakaji, Y. and Nelson, P.A. (1992). Equation error adaptive IIR filters for single channel response equalisation. *ISVR Technical Memorandum No.* 713.

25. Greenfield, R. and Hawksford, M.O. (1991). Efficient filter design for loudspeaker equalisation. *Journal of the Audio Engineering Society 39* 739-751.

**Claims**

1. A sound reproduction system comprising a plurality of loudspeakers (S1, S2) for positioning at positions spaced from a listener location (M1, M2), loudspeaker drive means (H) for driving the loudspeakers (S1, S2) in response to a plurality of channels of a sound recording (x), the loudspeaker drive means comprising a filter means (H), the sound recording (x) being suitable for playing normally through a plurality of speakers normally positioned generally symmetrically with respect to a listener location, characterised in that the filter means comprise digital filter means and the characteristics of the digital filter means (H) are so chosen as to create, in use of the reproduction system, at the listener location (M1, M2) a local sound field which is substantially equivalent to the local field that would result from playing the sound recording (x) through a plurality of loudspeakers driven without said digital filter means (H) and positioned at virtual source locations (V1, V2), at least one of the virtual source locations (V1, V2) being displaced substantially from the actual location (S1, S2) of the corresponding loudspeaker, the digital filter means (H) being designed in order to approximately reproduce in the sound field the desired signals (d) which are specified by the use of a filter matrix (A) used to relate the desired signals (d) to the recorded signals (x).

2. A sound reproduction system as claimed in claim 1 characterised in that each of said virtual source locations (V1, V2) is displaced from the actual location (S1, S2) of the corresponding loudspeaker.

3. A sound reproduction system as claimed in claim 1 or claim 2 characterised in that the actual locations (S1, S2) of the loudspeakers, during use of the sound reproduction system, are predetermined positions that are asymmetric with respect to the listener location (M1, M2), whereas said virtual source locations (V1, V2) created by the digital filter means (H) are substantially symmetrically positioned with respect to the listener location (M1, M2).

4. A sound reproduction system as claimed in claim 2 characterised in that the actual locations (S1, S2) of the loudspeakers, during use of the reproduction system, are predetermined positions that are more narrowly spaced from each other than the spacing of the virtual sources (V1, V2) created by the digital filter means (H).

5. A sound reproduction system as claimed in claim 1, characterised in that four loudspeakers (S1, S2, S3, S4) are employed, arranged in use at spaced-apart positions to create a sound field, first and second predetermined listener locations (M1, M2), (M3, M4) within the sound field, the loudspeakers being driven through digital filter means (H) by two channels ($x_1$, $x_2$) through a pair of loudspeakers positioned symmetrically with respect to the respective location.

6. A sound reproduction system as claimed in any one of claims 1 to 5, characterised in that said digital filter means (H) comprise adaptive filter means having a plurality of alterable filter coefficients, a processor implementing an algorithm which cyclically performs in turn a filtering operation utilising the filter, and a filter updating operation to update the filter coefficients, the algorithm being arranged in a cycle thereof to adjust (if necessary) only a limited number of the filter coefficients before performing a filtering operation.

7. A sound reproduction system as claimed in claim 6 characterised in that only one coefficient of the adaptive filter means is adjusted in each cycle.

8. A sound reproduction system as claimed in claim 6 or claim 7 in which the algorithm is the LMS algorithm.

9. A sound reproduction system as claimed in claim 6 or claim 7 characterised in that the algorithm is the filtered-x LMS algorithm.

10. A sound reproduction system as claimed in claim 9 characterised in that the filtered reference signal employed is calculated on a single-tap basis.

EP 0 649 589 B1

**Patentansprüche**

1. Tonwiedergabesystem mit einer Vielzahl von Lautsprechern (S1, S2) zur Positionierung an vom Standort eines Hörers (M1, M2) beabstandeten Stellen, mit einer Ansteuereinrichtung (H) zum Ansteuern der Lautsprecher (S1, S2) im Ansprechen auf eine Vielzahl von Kanälen einer Tonaufzeichnung (x), wobei die Lautsprecheransteuereinrichtung eine Filtereinrichtung (H) umfaßt und wobei die Tonaufzeichnung (x) zum normalen Abspielen über eine Vielzahl von normalerweise im wesentlichen symmetrisch zum Standort eines Hörers angeordneten Lautsprechern geeignet ist, **dadurch gekennzeichnet**, daß die Filtereinrichtung digitale Filtermittel aufweist und daß die Charakteristiken der digitalen Filtermittel (H) so gewählt sind, daß beim Einsatz des Wiedergabesystems am Standort des Hörers (M1, M2) ein lokales Schallfeld entsteht, das im wesentlichen äquivalent zu dem Ortsfeld ist, das sich beim Abspielen der Tonaufzeichnung (x) über eine Vielzahl von Lautsprechern ergäbe, die ohne die digitalen Filtermittel (H) angesteuert und an virtuellen Quellenstandorten (V1, V2) angeordnet sind, wobei mindestens einer der virtuellen Quellenstandorte (V1, V2) gegenüber dem realen Standort (S1, S2) des entsprechenden Lautsprechers erheblich versetzt ist und wobei die digitale Filtereinrichtung (H) so ausgelegt ist, daß sie in etwa in dem Schallfeld die gewünschten Signale (d) wiedergibt, die durch die Verwendung einer Filtermatrix (A) detailliert angegeben sind, welche dazu eingesetzt ist, die gewünschten Signale (d) in Beziehung zu den aufgezeichneten Signalen (x) zu setzen.

2. Tonwiedergabesystem nach Anspruch 1, **dadurch gekennzeichnet**, daß jeder der virtuellen Quellenstandorte (V1, V2) gegenüber dem realen Standort (S1, S2) des entsprechenden Lautsprechers versetzt ist.

3. Tonwiedergabesystem nach Anspruch 1 oder Anspruch 2, **dadurch gekennzeichnet**, daß die realen Standorte (S1, S2) der Lautsprecher während des Betriebs des Tonwiedergabesystems vorgegebene Positionen sind, die bezüglich des Standorts des Hörers (M1, M2) asymmetrisch sind, wohingegen die von der digitalen Filtereinrichtung (H) geschaffenen virtuellen Quellenstandorte (V1, V2) bezüglich des Standorts des Hörers (M1, M2) im wesentlichen symmetrisch positioniert sind.

4. Tonwiedergabesystem nach Anspruch 2, **dadurch gekennzeichnet**, daß die realen Standorte (S1, S2) der Lautsprecher während des Betriebs des Wiedergabesystems vorgegebene Positionen sind, welche in einem Abstand voneinander angeordnet sind, der kleiner ist als der Abstand zwischen den von der digitalen Filtereinrichtung (H) geschaffenen virtuellen Quellen (V1, V2).

5. Tonwiedergabesystem nach Anspruch 1, **dadurch gekennzeichnet**, daß vier Lautsprecher (S1, S2, S3, S4) eingesetzt und im Betrieb an voneinander beabstandeten Positionen so angeordnet sind, daß ein Schallfeld sowie erste (M1, M2) und zweite (M3, M4) vorgegebene Hörerstandorte innerhalb des Schallfelds entstehen, wobei die Lautsprecher über eine digitale Filtereinrichtung (H) von zwei Kanälen ($x_1$, $x_2$) über ein Paar Lautsprecher angesteuert werden, die bezüglich des jeweiligen Standorts symmetrisch positioniert sind.

6. Tonwiedergabesystem nach einem der Ansprüche 1 bis 5, **dadurch gekennzeichnet**, daß die digitale Filtereinrichtung (H) adaptive Filtermittel mit einer Vielzahl veränderbarer Filterkoeffizienten aufweist, wobei ein Prozessor einen Algorithmus realisiert, der zyklisch nacheinander einen Filtervorgang unter Verwendung des Filters und einen Filteraktualisierungsvorgang zur Aktualisierung der Filterkoeffizienten ausführt und wobei der Algorithmus in einem Zyklus so angeordnet ist, daß er (bei Bedarf) nur eine begrenzte Anzahl der Filterkoeffizienten einstellt, ehe ein Filtervorgang ausgeführt wird.

7. Tonwiedergabesystem nach Anspruch 6, **dadurch gekennzeichnet**, daß nur ein Koeffizient der adaptiven Filtermittel in jedem Zyklus eingestellt wird.

8. Tonwiedergabesystem nach Anspruch 6 oder Anspruch 7, bei welchem es sich bei dem Algorithmus um den LMS-Algorithmus handelt.

9. Tonwiedergabesystem nach Anspruch 6 oder Anspruch 7, **dadurch gekennzeichnet**, daß es sich bei dem Algorithmus um den x-gefilterten LMS-Algorithmus handelt.

10. Tonwiedergabesystem nach Anspruch 9, **dadurch gekennzeichnet**, daß das verwendete gefilterte Bezugssignal anhand eines einzigen Abgriffswerts berechnet wird.

## Revendications

1. Système de reproduction sonore comprenant plusieurs haut-parleurs ($S_1$, $S_2$) disposés en des positions éloignées d'un emplacement d'écoute (M1, M2), des moyens de commande (H) des haut-parleurs pour commander les haut-parleurs (S1, S2) en réponse à une multiplicité de canaux d'un enregistrement sonore (x), les moyens d'excitation des haut-parleurs comprenant des moyens de filtre (H), l'enregistrement sonore (x) étant approprié pour être normalement reproduit au moyen de plusieurs haut-parleurs normalement disposés de façon générale symétriquement par rapport à l'emplacement d'écoute, caractérisé en ce que les moyens de filtre comprennent des moyens de filtre numériques et en ce que les caractéristiques des moyens de filtre numériques (H) sont choisies de manière à créer, dans l'utilisation du système de reproduction, au niveau de l'emplacement d'écoute (M1, M2), un champ sonore local pratiquement équivalent au champ local qui résulterait de la reproduction de l'enregistrement sonore (x) par plusieurs haut-parleurs commandés sans lesdits moyens de filtre numériques (H) et disposés en des emplacements de source virtuels ($V_1$, $V_2$), l'un au moins des emplacements de source virtuels ($V_1$, $V_2$) étant notablement déplacé par rapport à l'emplacement réel ($S_1$, $S_2$) du haut-parleur correspondant, les moyens de filtre numériques (H) étant conçus pour reproduire approximativement dans le champ sonore les signaux désirés (d) qui sont spécifiés par l'utilisation d'une matrice filtrante (A) utilisée pour relier les signaux désirés (d) aux signaux enregistrés (x).

2. Système de reproduction sonore selon la revendication 1, caractérisé en ce que chacun desdits emplacements de source virtuels ($V_1$, $V_2$) est déplacé par rapport à l'emplacement réel ($S_1$, $S_2$) du haut-parleur correspondant.

3. Système de reproduction sonore selon l'une des revendication 1 et 2, caractérisé en ce que les emplacements réels ($S_1$, $S_2$) des haut-parleurs, pendant l'utilisation du système de reproduction sonore, sont des positions prédéterminées qui sont asymétriques par rapport à la position d'écoute ($M_1$, $M_2$), tandis que lesdits emplacements de source virtuels ($V_1$, $V_2$) créés par les moyens de filtre numériques (H) sont disposés de façon sensiblement symétrique par rapport à la position d'écoute ($M_1$, $M_2$).

4. Système de reproduction sonore selon la revendication 2, caractérisé en ce que les emplacements ($S_1$, $S_2$) des haut-parleurs, pendant l'utilisation du système de reproduction, sont des positions prédéterminées qui sont plus étroitement rapprochées l'une de l'autre que l'espacement des sources virtuelles ($V_1$, $V_2$) créées par les moyens de filtre numériques (H).

5. Système de reproduction sonore selon la revendication 1, caractérisé en ce qu'on emploie quatre haut-parleurs ($S_1$, $S_2$, $S_3$, $S_4$), disposés en utilisation en des positions espacées pour créer un champ sonore, des premiers et deuxièmes emplacements d'écoute prédéterminés ($M_1$, $M_2$), ($M_3$, $M_4$) à l'intérieur du champ sonore, les haut-parleurs étant commandés au moyen de moyens de filtre numériques (H) par deux canaux ($X_1$, $X_2$) au travers d'une paire de haut-parleurs disposés symétriquement par rapport à l'emplacement respectif.

6. Système de reproduction sonore selon l'une des revendications 1 à 5, caractérisé en ce que lesdits moyens de filtre numériques (H) comprennent des moyens de filtre adaptatifs ayant une multiplicité de coefficients de filtre modifiables, un processeur mettant en oeuvre un algorithme qui effectue cycliquement tour à tour une opération de filtrage utilisant le filtre, et une opération d'actualisation du filtre pour actualiser les coefficients de filtre, l'algorithme étant agencé dans un de ses cycles pour ajuster (si nécessaire) seulement un nombre limité de coefficients de filtre avant d'effectuer une opération de filtrage.

7. Système de reproduction sonore selon la revendication 6, caractérisé en ce que seulement un coefficient des moyens de filtre adaptatifs est ajusté dans chaque cycle.

8. Système de reproduction sonore selon la revendication 6 ou la revendication 7, dans lequel l'algorithme est l'algorithme LMS.

9. Système de reproduction sonore selon la revendication 6 ou la revendication 7, dans lequel l'algorithme est l'algorithme LMS à x filtres.

10. Système de reproduction sonore selon la revendication 9, caractérisé en ce que le signal de référence filtré est calculé sur une base d'une seule prise.

Figure 1

Source (*), virtual source (+) and microphone (o) locations

Figure 2

Figure 3

Figure 4

Figure 5

Figure 6

Figure 7

Figure 8

Figure 9

Source (*) and microphone (o) locations

Figure 10

X-coordinate (m)

Y-coordinate (m)

Figure 11

Figure 12

Figure 13

Figure 14

Figure 15

Figure 16

*(a)*

*(b)*

Figure 17

EP 0 649 589 B1

Figure 18